(19) Europäisches Patentamt
European Patent Office
Office européen des brevets

(11) **EP 4 228 001 A1**

(12) **EUROPEAN PATENT APPLICATION**
published in accordance with Art. 153(4) EPC

(43) Date of publication:
**16.08.2023 Bulletin 2023/33**

(21) Application number: **21879073.1**

(22) Date of filing: **04.08.2021**

(51) International Patent Classification (IPC):
**H01L 27/32** (2006.01)    **H01L 51/52** (2006.01)

(52) Cooperative Patent Classification (CPC):
**H10K 59/00; H10K 50/80**

(86) International application number:
**PCT/CN2021/110586**

(87) International publication number:
**WO 2022/078026 (21.04.2022 Gazette 2022/16)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **14.10.2020 CN 202011097946**

(71) Applicant: **GUANGDONG OPPO MOBILE
TELECOMMUNICATIONS
CORP., LTD.**
**Dongguan, Guangdong 523860 (CN)**

(72) Inventor: **LI, Zhilin**
**Dongguan, Guangdong 523860 (CN)**

(74) Representative: **Grassi, Stefano**
**Bugnion S.p.A.**
**Viale Lancetti, 17**
**20158 Milano (IT)**

(54) **DISPLAY APPARATUS AND ELECTRONIC DEVICE**

(57) A display apparatus and an electronic device. At least one first pixel unit comprising elliptic subpixels or circular subpixels is formed in a first pixel definition region of a pixel definition layer of the display apparatus. Each transparent anode of an anode layer is connected to a subpixel. A driving circuit layer is provided with a plurality of first driving units in a region outside the first pixel definition region. Each transparent anode is electrically connected to a first driving unit by means of a transparent conducting circuit.

FIG. 4

EP 4 228 001 A1

**Description**

CROSS REFERENCE OF RELATED APPLICATION

The present disclosure claims priority to a Chinese patent application No. CN 202011097946.6, filed to China National Intellectual Property Administration (CNIPA) on October 14, 2020, entitled "DISPLAY APPARATUS AND ELECTRONIC DEVICE", the content of which is hereby incorporated by reference in its entirety.

TECHNICAL FIELD

The present disclosure relates to the field of electronic technology, and in particularly, to a display apparatus and an electronic device.

DESCRIPTION OF RELATED ART

With the development of communication technology, electronic devices such as smart phones are becoming more and more popular. While using the electronic devices, the electronic devices may display pictures via display apparatuses.

In order to display better and with more contents, it is required to increase a screen ratio of the electronic devices. In the related art, an image sensor is integrated on a back side of the display apparatus, such that light can enter the image sensor through the display apparatus and thus lights entering the image sensor through the display apparatus enables the image sensor to be illuminated and imaged.

SUMMARY

An embodiment of the present disclosure provides a display apparatus and an electronic device, which can reduce a diffraction phenomenon formed by the display apparatus.

In a first aspect, an embodiment of the present disclosure provides a display apparatus, including:

a pixel definition layer, including a first pixel definition region, where at least one first pixel unit is formed in the first pixel definition region, and each of the at least one first pixel unit includes an elliptical subpixel or a circular subpixel;
an anode layer, defined on a side of the pixel definition layer and including multiple transparent anodes, where each of the multiple transparent anodes is connected to one subpixel;
a driving circuit layer, arranged at intervals on a side of the anode layer back from the pixel definition layer, where the driving circuit layer is provided with multiple first driving units in a region apart from the first pixel definition region; and
a first transparent conductive layer, arranged between the anode layer and the driving circuit layer, where the first transparent conductive layer is formed with multiple curved transparent conducting circuits, and each of the multiple transparent anodes is electrically connected to one of the multiple first driving units through one of the multiple transparent conducting circuits.

In a second aspect, an embodiment of the present disclosure provides an electronic device, including:

a display apparatus, including: a pixel definition layer, an anode layer, a first transparent conductive layer and a driving circuit layer stacked sequentially, where the pixel definition layer includes a first pixel definition region, and at least one first pixel unit is formed in the first pixel definition region, and each of the at least one first pixel unit includes an elliptical subpixel or a circular subpixel; the anode layer includes multiple transparent anodes, and each of the multiple transparent anodes is connected to one subpixel; the driving circuit layer is provided with multiple first driving units in a region apart from the first pixel definition region ; the first transparent conductive layer is formed with multiple curved transparent conducting circuits; and each of the multiple transparent anodes is electrically connected to one of the multiple first driving units through one of the multiple transparent conducting circuits; and an image sensor, arranged on a side of the display apparatus, where the image sensor is configured to receive light passing through the display apparatus.

BRIEF DESCRIPTION OF DRAWINGS

In order to more clearly explain technical solutions of embodiments of the present disclosure, accompanying drawings that required to be used in the description of the embodiments will be briefly introduced hereinafter.

FIG. 1 illustrates a first schematic structural view of an electronic device according to an embodiment of the present disclosure.

FIG. 2 illustrates a first schematic structural view of a display apparatus illustrated in FIG. 1.

FIG. 3 illustrates a first cross-sectional view of the display apparatus illustrated in FIG. 2 along a direction P1 to P2.

FIG. 4 illustrates a schematic structural view of a pixel definition layer illustrated in FIG. 3.

FIG. 5 illustrates a first schematic structural view of a subpixel illustrated in FIG. 4.

FIG. 6 illustrates a second schematic structural view of the subpixel illustrated in FIG. 4.

FIG. 7 illustrates a third schematic structural view of the subpixel illustrated in FIG. 4.

FIG. 8 illustrates a fourth schematic structural view of the subpixel illustrated in FIG. 4.

FIG. 9 illustrates a first diffraction pattern of a first display area according to an embodiment of the present disclosure.

FIG. 10 illustrates a second diffraction pattern of the first display area according to an embodiment of the present disclosure.

FIG. 11 illustrates a third diffraction pattern of the first display area according to an embodiment of the present disclosure.

FIG. 12 illustrates a second cross-sectional view of the display apparatus illustrated in FIG. 2 along the direction P1 to P2.

FIG. 13 illustrates a second schematic structural view of the display apparatus illustrated in FIG. 1.

FIG. 14 illustrates a third cross-sectional view of the display apparatus illustrated in FIG. 2 along the direction P1 to P2.

FIG. 15 illustrates a first cross-sectional view of the display apparatus illustrated in FIG. 1 along M1 to M2.

FIG. 16 illustrates a second cross-sectional view of the display apparatus illustrated in FIG. 1 along M1 to M2.

FIG. 17 illustrates a third cross-sectional view of the display apparatus illustrated in FIG. 1 along M1 to M2.

FIG. 18 illustrates a fourth cross-sectional view of the display apparatus illustrated in FIG. 1 along M1 to M2.

## DETAILED DESCRIPTION OF EMBODIMENTS

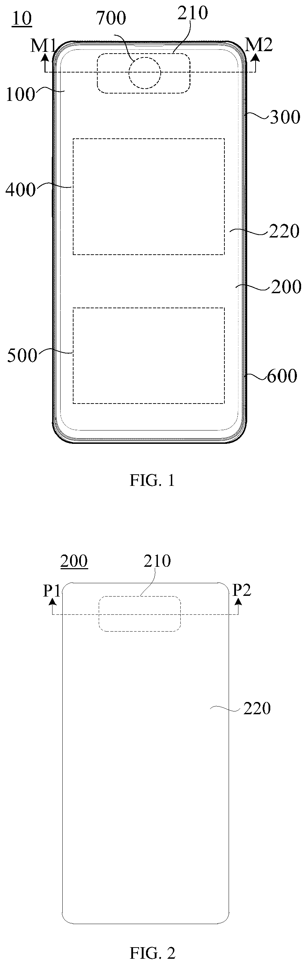

The technical solutions of the embodiments of the present disclosure will be described clearly and completely with reference to FIGS. 1 to 18 in the embodiments of the present disclosure. It is apparent that the described embodiments are merely part but not whole of the embodiments of the present disclosure. Based on the embodiments of the present disclosure, all other embodiments obtained by those skilled in the art without creative labor also fall in the scope of protection of the present disclosure.

An embodiment of the present disclosure provides an electronic device. The electronic device may be a mobile terminal equipment such as a mobile phone and a tablet computer, and may be an equipment having a display apparatus such as a gaming equipment, an augmented reality (AR) equipment, a virtual reality (VR) equipment, a vehicle-mounted computer, a laptop computer, a data storage device, an audio playback device, a video playback device, and a wearable device. The wearable device may be a smart bracelet, smart glasses, or the like

As illustrated in FIG. 1, FIG. 1 illustrates a first schematic structural view of an electronic device according to an embodiment of the present disclosure. The electronic device 10 includes a cover plate 100, a display apparatus 200, a middle frame 300, a circuit board 400, a battery 500, a back cover 600, and an image sensor 700.

The display apparatus 200 can be configured to display information such as images and texts. The display apparatus 200 may be an Organic Light-Emitting Diode (OLED) display apparatus.

The cover plate 100 may be installed onto the middle frame 300, and the cover plate 100 is configured to cover the display apparatus 200 to protect the display apparatus 200 from being scratched or damaged by water. The cover plate 100 may be a transparent glass cover plate 100, such that a user can observe contents displayed by the display apparatus 200 through the cover plate 100. The cover plate 100 may be a sapphire glass cover plate 100.

The display apparatus 200 may be mounted onto the middle frame 300 and connected to the back cover 600 through the middle frame 300 to form a display surface of the electronic device 10. The display apparatus 200, acting as a front housing of electronic device 10, forms a housing of the electronic device 10 together with the back cover for accommodating other electronic devices of the electronic device 10. In some embodiments, the housing can be configured to accommodate electronic devices such as a processor, a memory, and one or more sensors of the electronic device 10.

The middle frame 300 may have a thin plate or sheet structure, or may have a hollow frame structure. The middle frame 300 is configured to provide support for electronic components or electronic devices in the electronic device 10, so as to install the electronic components and the electronic devices in the electronic device 10 together. In some embodiments, the image sensor 700, a receiver, the circuit board 400, the battery 500 and other electronic devices in the electronic device 10 can be mounted onto the middle frame 300 for fixing.

The circuit board 400 may be mounted onto the middle frame 300. The circuit board 400 may be a mainboard of the electronic device 10. Specifically, one, two or more of electronic devices such as a microphone, a speaker, a receiver, an earphone interface, a universal serial bus interface (USB interface), a camera assembly, a distance sensor, an environmental sensor, a gyroscope and a processor can be integrated on the circuit board 400.

In some embodiments, the display apparatus 200 may be electrically connected to the circuit board 400, and the display of the display apparatus 200 is controlled through the processor on the circuit board 400. The image sensor 700 may be arranged inside the display apparatus 200. The display apparatus 200 and the image sensor 700 can be electrically connected with the processor, and the image sensor 700 can acquire signals transmitted through the display apparatus 200 to realize corresponding functions of the image sensor 700.

In some embodiments, the image sensor 700 may be a front camera module of the electronic device 10. When the processor receives a shooting instruction, the processor controls the front camera module to collect images through the display apparatus 200. When the processor does not receive the shooting instruction but receives an instruction for display an image, the processor controls the display apparatus 200 to display the image.

In some embodiments, the image sensor 700 may include a camera lens, a color filter film, a light sensor, a digital-to-analog conversion device, and a digital processing chip. The camera lens may be composed of multiple lenses. The camera lens can collect ambient light transmitted through a first display area 210. The color filter film can decompose the ambient light into monochromatic light such as red light, blue light and green light. The light sensor is a kind of semiconductor chip, and a surface of the semiconductor chip contains hundreds of thousands to millions of photodiodes. When the photodiodes are irradiated by light, charges can be generated. The light sensor can receive and convert the filtered three-color ambient light into different electrical signals under the irradiation of the three-color ambient light. The digital-to-analog conversion device can convert the electrical signals into digital image signals. The digital processing chip can process the digital image signals and obtain final image information.

It should be understood that after the light sensor collects the ambient light, the digital processing chip can obtain the final image information after processing such as white balance, demosaicing, noise reduction, color gamut conversion, gamma correction, compression, etc.

The battery 500 may be mounted onto the middle frame 300. Further, the battery 500 may be electrically connected to the circuit board 400, so that the battery 500 can supply power to the electronic device 10. The circuit board 400 may be provided with a power management circuit. The power management circuit is configured to distribute a voltage provided by the battery 500 to various electronic devices in the electronic device 10. In some embodiments, the battery 500 may be a rechargeable battery 500. As another example, the battery 500 may be a lithium ion battery 500.

The back cover 600 may be located at a side of the circuit board 400 facing away from the display apparatus 200, that is, the back cover 600 is located at an outermost part of the electronic device 10 and is configured to form an external outline of the electronic device 10. The back cover 600 may be integrally formed. In a molding process of the back cover 600, structures such as a rear camera hole and a fingerprint identification module mounting hole can be formed on the back cover 600.

The back cover 600 may be made of metal, such as magnesium alloy, stainless steel and other metals. It should be noted that a material of the back cover 600 of the embodiments of the present disclosure is not limited thereto, and other ways can be also adopted. In some embodiments, the back cover 600 may be made of plastic. For another example, the back cover 600 may be made of ceramic or glass. For another example, the back cover 600 may include a plastic part and a metal part, and the back cover 600 may have a housing structure in which metal and plastic cooperate with each other. Specifically, the metal part can be molded first, in some embodiments, a magnesium alloy substrate is formed by injection molding, and then a plastic substrate is formed through injecting plastic on the magnesium alloy substrate, thereby forming a complete housing structure.

As illustrated in FIG. 2 combined with FIG. 1, FIG. 2 illustrates a first schematic structural view of a display apparatus illustrated in FIG. 1. The display apparatus 200 may include a first display area 210 and a second display area 220 connected to each other. The cover plate 100 is arranged outside the first display area 210 and the second display area 220, covering the first display area 210 and the second display area 220. Electronic components such as the circuit board 400 and the battery 500 of the electronic device 10 can be arranged inside the first display area 210. That is to say, the electronic components such as the circuit board 400 and the battery 500 may be arranged between the first display area 210 and the back cover 600. The image sensor 700 may be arranged inside the first display area 210. The camera lens of the image sensor 700 can be arranged to face towards the first display area 210, and the image sensor 700 is configured to acquire an external light signal transmitted through the first display area 210 for imaging.

Specifically, both the first display area 210 and the second display area 220 can be configured to display texts or images. The first display area 210 and the second display area 220 can together display a preset image, in some embodiments, the second display area 220 displays a part of the preset image, and the first display area 210 displays the rest of the preset image. The first display area 210 and the second display area 220 can also display different images. In some embodiments, the second display area 220 displays a preset image and the first display area 210 displays a taskbar image.

It should be understood that an area of the first display area 210 can be much smaller than that of the second display area 220, the second display area 220 can be arranged around the first display area 210, and a periphery of the first display area 210 can completely be adjacent to the second display area 220. The first display area 210 may be located in the middle of the second display area 220. The second display area 220 may also partially surround the first display area 210, and part of an edge of the first display area 210 is adjacent to the second display area 220. A corner of the second display area 220 may also be irregular, in some embodiments, the corner of the second display area has a notch, and the first display area 210 may be located in the notch.

It should be understood that a position of the first display area 210 and the second display area 220 is not limited to the above embodiments, and other technical solutions that the display apparatus 200 includes the first display area 210 and the second display area 220 are within the scope of protection of the present disclosure.

It should be noted that the second display area 220 in the embodiments of the present disclosure can be used as a main display area of the display apparatus 200, the first display area 210 can be used as an auxiliary display area of the display apparatus 200. The second display area 220 can be an active matrix organic light Emitting display (AMOLED), and the first display area 210 can be an AMOLED or a passive matrix organic light Emitting display (PMOLED). Although the AMOLED displays better than PMOLED, the first display area 210 is small and displays very few contents, and the first display area 210 is located at an edge of the display apparatus 200, the displayed contents are of low importance, therefore the first display area 210 can adopt the PMOLED. It is required only one thin film transistor (TFT) to drive the passively driven first display area 210, the number of opaque TFT is very small, thereby greatly improving the light transmittance of the first display area 210.

It should be understood that in the description of the present disclosure, terms such as "first" and "second" are merely used to distinguish similar objects, and cannot be understood as indicating or implying relative importance or implicitly indicating the number of indicated technical features.

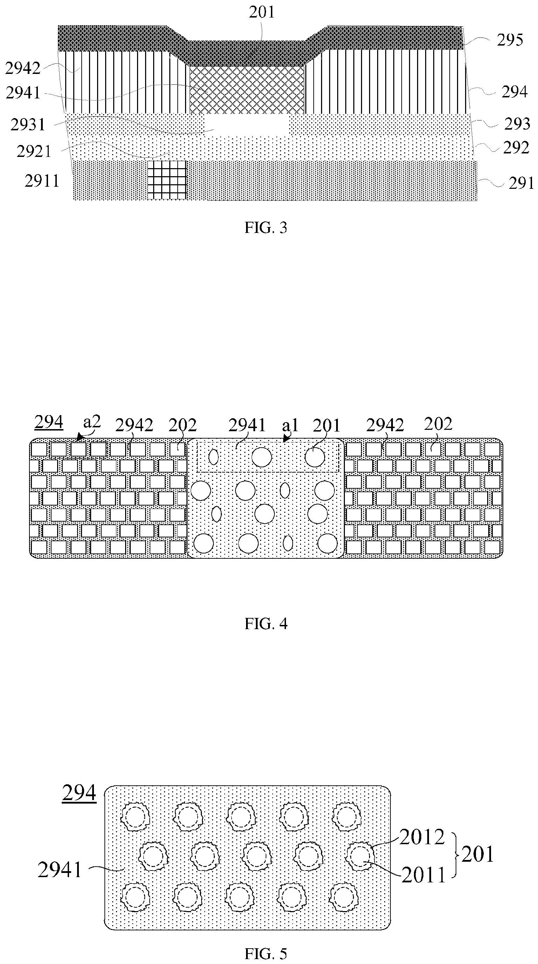

As illustrated in FIG. 3, FIG. 3 illustrates a first cross-sectional view of the display apparatus illustrated in FIG. 2 along a direction P1 to P2. The display apparatus 200 may include layered structures such as a driving circuit layer 291, a first transparent conductive layer 292, an anode layer 293, a pixel definition layer 294, and a common electrode layer 295, which are sequentially stacked.

The pixel definition layer 294 includes a first pixel definition region 2941, which may be arranged correspond to the first display area 210 of the display apparatus 200. As illustrated in FIG. 4 combined with FIG. 3, FIG. 4 illustrates a schematic structural view of a pixel definition layer illustrated in FIG. 3. The first pixel definition region 2941 has multiple pixel holes, and each of the multiple pixel holes is provided with a pixel unit including an organic luminescent material. The first pixel definition region 2941 may be formed with at least one first pixel unit a1, which may include one or more subpixels 201. In some embodiments, the first pixel unit a1 may include a red subpixel, a green subpixel, and a blue subpixel. The subpixel 201 may be at least an elliptical subpixel or a circular subpixel, so that the first pixel unit a1 may include the elliptical subpixel or the circular subpixel.

The anode layer 293 may be defined on a side of the pixel definition layer 294, and the anode layer 293 is electrically connected with the driving circuit layer 291 and used for controlling each of first driving units 2911 of the driving circuit layer 291. The anode layer 293 includes multiple transparent anodes 2931, which may be arranged correspond to the first display area 210 of the display apparatus 200, that is to say, the multiple transparent anodes 2931 may be arranged correspond to the first pixel definition region 2941. One transparent anode 2931 may be electrically connected to one subpixel 201 of the pixel definition layer 294.

The driving circuit layer 291 is at intervals arranged at a side of the anode layer 293 back from the pixel definition layer 294, and the driving circuit layer 291 is provided with multiple first driving units in a region apart from the first pixel definition region 2941. In some embodiments, the region apart from the first pixel definition region 2941 may refer to a region apart from the first display region 210, and may refer to a region corresponding to the second display region 220. Each of the first driving units 2911 is configured to drive one subpixel 201. The first driving unit 2911 includes an opaque part such as a thin film transistor (TFT).

The first transparent conductive layer 292 is arranged between the anode layer 293 and the driving circuit layer 291. The first transparent conductive layer 292 is formed with multiple curved transparent conducting circuits 2921, and the transparent conducting circuits 2921 can be partially arranged correspond to the first display area 210 and partially arranged correspond to the second display area 220. Each transparent anode 2931 is electrically connected to one first driving unit 2911 through one transparent conducting circuit 2921.

The common electrode layer 295 is arranged on the pixel definition layer 294, which may be arranged correspond to the first display area 210 and the second display area 220. The anode layer 293 and the common electrode layer 295 are respectively arranged on opposite sides of the pixel definition layer 294, and drive the multiple subpixels 201 together with the multiple first driving units 2911 of the driving circuit layer 291.

In the display apparatus 200 of the embodiments of the present disclosure, the driving circuit layer 291 can be electrically connected to a positive electrode of a power supply and the common electrode layer 295 can be electrically connected to a negative electrode of the power supply. When the positive electrode of the power supply and the negative electrode of the power supply are energized, an electric current will flow in the driving circuit layer 291, the anode layer 293, the pixel definition layer 294, and the first transparent conductive layer 292, so that under the action of the electric current, the subpixels 201 of the pixel definition layer 294 are driven to emit light to thereby realize the display function of the display apparatus 200.

As of the electronic device 10 of the embodiments of the present disclosure, when the image sensor 700 is arranged inside the display apparatus and external light passes through the first display area 210 of the display apparatus 200, a part of the anode layer 293 corresponding to the first display area 210 is provided with the transparent anode 2931, which has little diffraction interference to the external light. Moreover, the opaque first driving unit 2911 is arranged to not correspond to the first display area 210, and the opaque first driving unit 2911 will not affect the incidence of the external light at all, so that a light transmittance of the external light in the first display area 210 is high. Further, when the external light passes through the circular or elliptical subpixels 201, in the diffraction spectrum formed by the external light, an energy of the diffraction spectrum is more concentrated in primary diffraction stripes, and energy of each secondary diffraction stripe is lower, and the secondary diffraction stripes will be less, so that a diffraction phenomenon can be alleviated.

In order to further reduce the diffraction interference, as illustrated in FIG. 5, FIG. 5 illustrates a first schematic structural view of the subpixel illustrated in FIG. 4. In the display apparatus 200 of the embodiments of the present disclosure, each subpixel 201 may include a main body portion 2011 and an edge portion 2012 connected with each other. In a direction parallel to the pixel definition layer 294, a cross section of the main body portion 2011 may be circular or elliptical. A cross section of the edge portion 2012 may be approximately annular, which may include an outer contour and an inner contour. The inner contour surrounds and fits an outer periphery of the main body portion 2011, and may be a closed circular or elliptical curve. The outer contour may include multiple curves with different curvatures, and the multiple curves with different curvatures are connected end to end to form a closed curve around the main body portion 2011.

It can be understood that the multiple curves with different curvatures can form an irregular closed curve around the main body portion 2011. The irregular closed curve can mean that the curve is not a regular polygon such as a regular triangle and a regular quadrangle; the irregular closed curve is not a common triangle, square, rectangle or parallelogram; the irregular closed curve is also not a regular circle or ellipse; and the irregular curve is not a curve formed by connecting multiple identical arcs.

It can be understood that when the outer contour of the edge portion 2012 includes multiple curves, curvatures of any two adjacent curves of the multiple curves may be different. Therefore, when the light passes through any two adjacent curves, the diffraction phenomena formed are more likely to cancel each other, so that a probability of diffraction is greatly reduced when the light passes through the whole edge portion 2012, and the diffraction phenomena can be alleviated to a great extent.

In the display apparatus 200 of the embodiments of the present disclosure, when the subpixel 201 includes the edge portion 2012 composed of the curves with different curvatures, under the influence of the curves with different curvatures, when the external light passes through the edge portion 2012 of the subpixel 201, the diffraction phenomena formed at different parts on the edge portion 2012 will cancel each other out, thereby reducing the formation of diffraction fringes and diffraction interference.

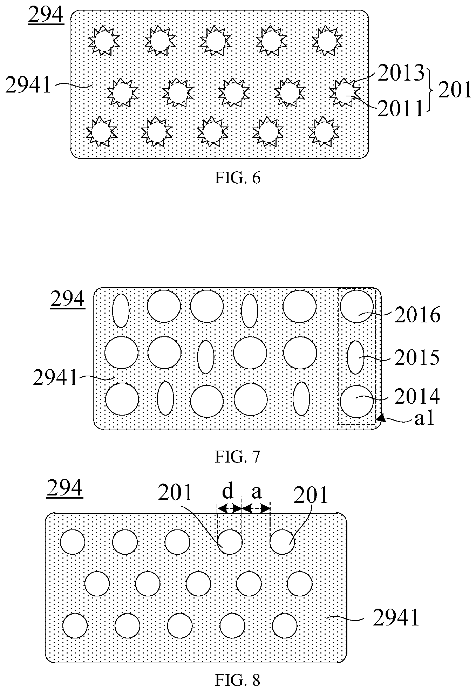

As illustrated in FIG. 6, FIG. 6 illustrates a second schematic structural view of the subpixel illustrated in FIG. 4. In the display apparatus 200 of the embodiments of the present disclosure, each subpixel 201 may include a main body portion 2011 and a protrusion portion 2013 connected with each other. The protrusion portion 2013 may include multiple protrusions arranged at intervals, and the protrusions are arranged around and protrude from the outer periphery of the main body portion 2011.

It can be understood that the multiple protrusions can be formed by multiple curves with different curvatures, and each of the multiple protrusions can extend from an outer periphery of the main body portion 2011 in a direction away from the main body portion 2011. In this case, the outer periphery of the subpixel 201 may include multiple protrusions.

It can be understood that the number of the multiple protrusions can be in a range from 20 to 30. In this case, an outer periphery of the edge portion 2012 can include 20 to 30 curves connected with each other end to end, and the outer periphery of the subpixel 201 can be irregular curves.

In the display apparatus 200 of the embodiments of the present disclosure, when the subpixel 201 includes an outer periphery composed of multiple protrusions, due to larger bending curvatures of the protrusions, when the external light passes through the edge portion 2012 of the subpixel 201, the diffraction phenomena formed by the different protrusions on the subpixel 201 will cancel each other out, thereby reducing the formation of diffraction fringes and diffraction interference.

As illustrated in FIGS. 5 and 6, a diameter of a cross section of the subpixel 201 in the direction parallel to the pixel definition layer 294 may be a non-integer multiple of a half of a target wavelength. It can be understood that the light with the target wavelength can be a light within a certain wavelength range. In some embodiments, when the light with the target wavelength is in a visible light band (380 nm to 750 nm band), in this case, the diameter of the cross section of the subpixel 201 can be a non-integer multiple of a half of any wavelength in the whole visible light band range, that is to say, the diameter of the cross section of the subpixel 201 can avoid an integer multiple of a half of any wavelength in the whole band range.

It can be understood that the non-integer multiple of the half of the target wavelength means that the diameter of the cross section of the subpixel 201 is not an integer multiple of the half of the target wavelength, that is to say, the diameter D ≠ n·1/2·λ (target wavelength), and n is a positive integer.

It can be understood that when the cross section of the subpixel 201 in the direction parallel to the pixel definition layer 294 is circular, that is to say, when the subpixel 201 is a cylindrical pixel, the diameter between any two points passing through a center of the subpixel 201 in the cross section in the direction parallel to the pixel definition layer 294 can be a non-integer multiple of a half of the target wavelength. The center of the subpixel 201 may be a center of a circular cross section of the subpixel 201 in the direction parallel to the pixel definition layer 294.

It can be understood that when the cross section of the subpixel 201 in the direction parallel to the pixel definition layer 294 is elliptical, that is to say, when the subpixel 201 is an elliptical column pixel, the diameter between any two points passing through a center of the subpixel 201 on the cross section of the subpixel 201 in the direction parallel to the pixel definition layer 294 may also be a non-integer multiple of a half of the target wavelength. The center of the subpixel 201 may be an intersection of a major axis and a minor axis of the elliptical cross-section of the subpixel 201 in the direction parallel to the pixel definition layer 294.

Based on an optical principle, when light outside the display apparatus 200 passes through the subpixel 201, because a light transmittance of the subpixel 201 is different from that of the air and a pixel interval area, the subpixel 201 is an obstacle for the air and the pixel interval area, and the light will deviate from an original straight-line propagation trajectory when passing through the obstacle (i.e., the subpixel 201), forming a diffraction phenomenon. In the display apparatus 200 of the embodiments of the present disclosure, the cross section of the subpixel 201 is a circular or elliptical pixel, therefore, when the subpixel 201 blocks the light with the target wavelength, because the diameter of the cross section of the subpixel 201 is a non-integer multiple of a half of the target wavelength, the energy can be more concentrated in the primary diffraction stripes, and the energy of each secondary diffraction stripe is lower, and secondary diffraction stripes will be less, so that the diffraction phenomenon can be alleviated.

As illustrated in FIG. 7, FIG. 7 illustrates a third schematic structural view of the subpixel illustrated in FIG. 4. In the display apparatus 200 of the embodiments of the present disclosure, the first pixel unit a1 in the first pixel definition region 2941 may include a first subpixel 2014, a second subpixel 2015, and a third subpixel 2016 arranged at intervals, or the subpixel 201 may include the first subpixel 2014, the second subpixel 2015, and the third subpixel 2016. In the direction parallel to the pixel definition layer 294, a cross-sectional area of each of the first subpixel 2014 and the second subpixel 2015 may be larger than that of the third subpixel 2016.

It can be understood that the first subpixel 2014, the second subpixel 2015 and the third subpixel 2016 can be made of organic luminescent materials, which can emit light by themselves under the action of an electric current. In some embodiments, the first subpixel 2014 may emit light of a first color, the second subpixel 2015 may emit light of a second color, and the third subpixel 2016 may emit light of a third color. The first color, the second color and the third color may be different from each other.

It can be understood that in the direction parallel to the pixel definition layer 294, a cross section of each of the first subpixel 2014 and the second subpixel 2015 may be a circle, and a cross section of the third subpixel 2016 may be an ellipse, where a size of a major axis of the ellipse can be equal to a diameter of the circle, and a size of a minor axis of the ellipse can be smaller than the diameter of the circle, so that the cross-sectional area of the third subpixel 2016 is smaller than that of each of the first subpixel 2014 and the second subpixel 2015.

It can be understood that thicknesses of the first subpixel 2014, the second subpixel 2015 and the third subpixel 2016 may be the same, that is to say, in the first pixel definition region 2941, upper surfaces of the first subpixel 2014, the second subpixel 2015 and the third subpixel 2016 can be in a same plane, and lower surfaces of the first subpixel 2014, the second subpixel 2015 and the third subpixel 2016 may also be in a same plane.

In the display apparatus 200 according to the embodiments of the present disclosure, in the direction parallel to the pixel definition layer 294, the cross section of the third subpixel 2016 is smaller than that of each of the first subpixel 2014 and the second subpixel 2015, so that a space occupied by the third subpixel 2016 is smaller. Since light will diffract only when it passes through an obstacle, the third subpixel 2016, which occupies a smaller space, has a smaller probability of diffraction, so that the probability of diffraction of the whole display apparatus 200 may be reduced and the diffraction interference may be reduced.

Specifically, in the direction parallel to the pixel definition layer 294, when the cross-sectional area of each of the first subpixel 2014 and the second subpixel 2015 is larger than that of the third subpixel 2016, the first subpixel 2014, the second subpixel 2015 and the third subpixel 2016 can be made of different luminescent materials, such that the first subpixel 2014 can have a first luminescence decay frequency, the second subpixel 2015 may have a second luminescence decay frequency, and the third subpixel 2016 may have a third luminescence decay frequency, where each of the first luminescence decay frequency and the second luminescence decay frequency may be greater than the third luminescence decay frequency.

In the display apparatus 200 of the embodiments of the present disclosure, when a luminescence decay frequency of each of the first subpixel 2014 and the second subpixel 2015 is greater than a luminescence decay frequency of the third subpixel 2016, an intensity of light emitted by each of the first subpixel 2014 and the second subpixel 2015 per unit area will be weakened under the action of the same electric current after the same use time, which will be smaller than an intensity of light emitted by the third subpixel 2016 per unit area. Since the cross-sectional area of each of the first subpixel 2014 and the second subpixel 2015 is larger than the cross-sectional area of the third subpixel 2016, a total light intensity emitted by the first subpixel 2014 and the second subpixel 2015 can be the same as that emitted by the third subpixel 2016, as such, in the display apparatus 200 of the embodiments of the present disclosure, the first subpixel 2014, the second subpixel 2015 and the third subpixel 2016 can emit light with a same brightness, which can compensate the attenuation of pixels and improve the service life of the whole display apparatus 200.

As illustrated in FIG. 7, FIG. 7 illustrates a third schematic structural view of the subpixel illustrated in FIG. 4. In the display apparatus 200 of the embodiments of the present disclosure, the first display area 210 may include multiple subpixels 201 arranged at intervals, that is to say, the multiple subpixels 201 are arranged at intervals in the first pixel definition region 2941. In the direction parallel to the pixel definition layer 294, a diameter d of a cross section of each subpixel 201 may not be half of a spacing a between two adjacent subpixels, that is to say, the diameter of the cross section of the subpixel 201 may be greater than or less than half of the spacing a between two adjacent subpixels.

It can be understood that in the direction parallel to the pixel definition layer 294, the diameter of the cross section of the subpixel 201 can be referred to the above description, and will not be repeated herein. It can be understood that, as illustrated in FIG. 8, in the direction parallel to the pixel definition layer 294, the spacing a between two adjacent subpixels 201 can be a distance between two points on the edges of two subpixels 201, where a connecting line of the two points on the edges of two subpixels 201 will pass through the centers of the two subpixels 201.

It can be understood that in the direction parallel to the pixel definition layer 294, the cross sections of the two subpixels 201 in the embodiments of the present disclosure can be both elliptical, both circular, or one of which is circular and the other is elliptical. Of course, the two subpixels 201 in the embodiments of the present disclosure may also have other shapes, and the specific shapes are not limited in the embodiments of the present disclosure.

It can be understood that, assuming that a refractive index of the pixel interval area of the first display area 210 is $n_1$ and a thickness of the pixel interval area of the first display area 210 is $d_1$, a refractive index of the subpixel 201 is $n_2$ and a thickness of the subpixel 201 is $d_2$, the spacing between two adjacent subpixels 201 is a, a diameter of the subpixel 201 is d, and a distance from a light source to the first display area 210 is $n_0$, a light transmittance function of light passing through the first display area 210 can be expressed as:

$$t_{unit}(x) = \begin{cases} exp\left[i\frac{2\pi}{\lambda} \cdot \left(n_1 d_1 + n_0(d_2 - d_1)\right)\right], & 0 < x \le a \\ exp\left[i\frac{2\pi}{\lambda} \cdot \left(n_2 d_2\right)\right], & a < x < d \end{cases}.$$

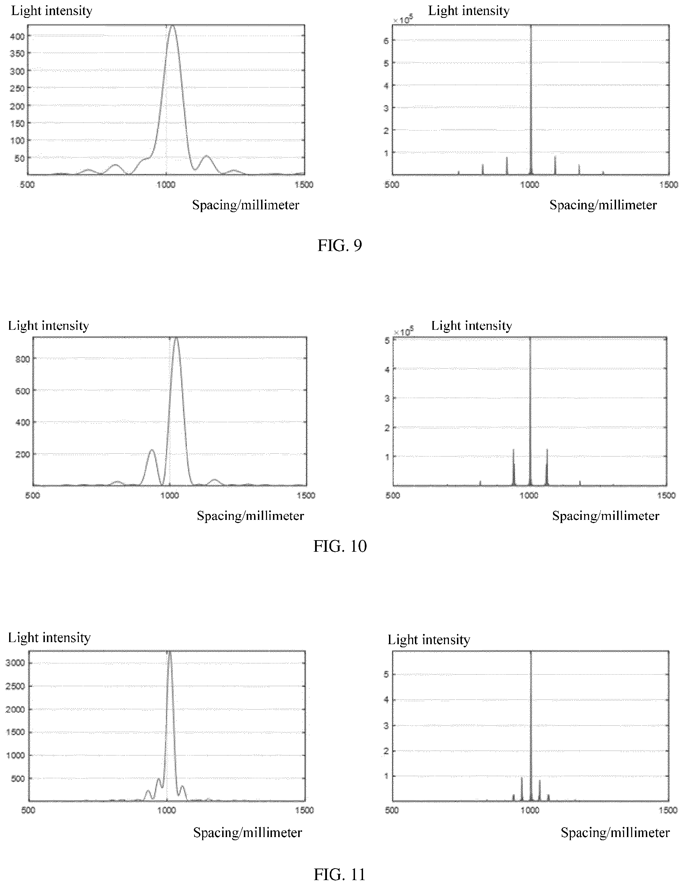

Different diffraction patterns can be obtained by changing the values of a and d respectively. In some embodiments, as illustrated in FIGS. 9 to 11, FIG. 9 illustrates a first diffraction pattern of the first display area according to the embodiments of the present disclosure, FIG. 10 illustrates a second diffraction pattern of the first display area according to the embodiments of the present disclosure, and FIG. 11 illustrates a third diffraction pattern of the first display area according to the embodiments of the present disclosure. In addition, in each of FIGS. 9 to 11, a diffraction intensity envelope view of the first display area 210 is illustrated on the left, and a diffraction order distribution view of the first display area 210 is illustrated on the right.

In FIG. 9, the spacing a between two adjacent subpixels 201 is 18 microns, and the diameter d of the subpixel 201 is 23 microns. In FIG. 10, the spacing a between two adjacent subpixels 201 is 18 microns, and the diameter d of the subpixel 201 is 33 microns. In FIG. 11, the spacing a between two adjacent subpixels 201 is 18 microns, and the diameter d of the subpixel 201 is 63 microns.

By comparing FIG. 9 to FIG. 11, it can be seen that the diffraction order spacing is inversely proportional to the diameter d. With the increase of the diameter d, the diffraction order spacing is gradually reduced. When a ratio of the spacing a to the diameter d is close to a=0.5d, the diffraction intensity of each of the ±1 orders is the strongest. Based on this, in the display apparatus 200 of the embodiments of the present disclosure, the diameter of the cross section of the subpixel 201 may not be half of the spacing a between two adjacent subpixels 201, when the light passes through the first display area 210, a secondary diffraction intensity may be weak, so that the diffraction may be reduced.

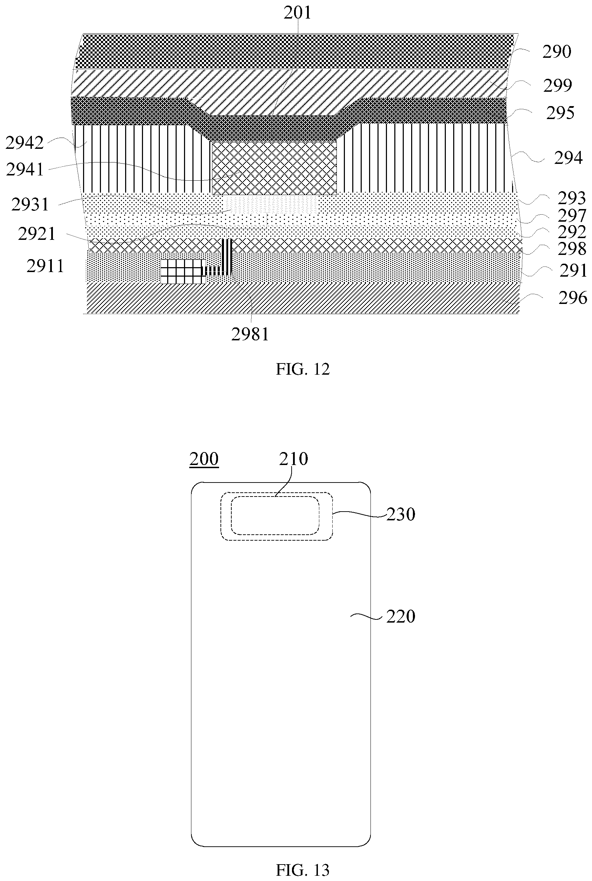

As illustrated in FIG. 12 combined with FIG. 2, FIG. 12 illustrates a second cross-sectional view of the display apparatus illustrated in FIG. 2 along the direction P1 to P2.

The first display area 210 of the display apparatus 200 includes a substrate 296, a driving circuit layer 291, a first planarization layer 298, a first transparent conductive layer 292, a second transparent conductive layer 297, an anode layer 293, a pixel definition layer 294, a common electrode layer 295, a second planarization layer 299, and a touch layer 290 which are sequentially stacked.

The substrate 296 can be used as a bearing platform for the display apparatus 200, and the substrate 296 may be made of glass, plastic, resin or other materials. In some embodiments, polyimide (PI) can be used as the material of the substrate 296.

The driving circuit layer 291 is arranged on the substrate 296, and includes first driving units 2911 for driving subpixels 201 of the first display area 210, and each of the first driving units 2911 includes at least one thin film transistor (TFT). Further, a source electrode and a drain electrode of the thin film transistor are located in a same layer, and a gate electrode of the thin film transistor is located between the source electrode and a luminescent layer.

The anode layer 293 is arranged on the driving circuit layer 291, and is electrically connected to the driving circuit layer 291 and used for controlling each first driving unit 2911 of the driving circuit layer 291. The anode layer 293 includes multiple transparent anodes 2931, which may be arranged correspond to the first display area 210 of the display apparatus 200, that is to say, the multiple transparent anodes 2931 may be arranged correspond to the first pixel definition region 2941. One transparent anode 2931 may be electrically connected to one subpixel 201 of the pixel definition layer 294.

The luminescent layer 294 is arranged on the anode layer 293, and includes a first pixel definition region 2941 having multiple pixel holes, and each of the multiple pixel holes is provided with a subpixel 201including an organic luminescent material.

The first transparent conductive layer 292 is arranged between the anode layer 293 and the driving circuit layer 291. The first transparent conductive layer 292 is formed with multiple curved transparent conducting circuits 2921, which may be arranged to partially correspond to the first display area 210 and to partially correspond to the second display area 220. Each transparent anode 2931 is electrically connected to one first driving unit 2911 through a transparent conducting circuit 2921.

The second transparent conductive layer 297 is arranged between the anode layer 293 and the driving circuit layer 291. The second transparent conductive layer 297 may be stacked with the first transparent conductive layer 292, that is to say, the second transparent conductive layer 297 may be arranged between the driving circuit layer 291 and the first transparent conductive layer 292, and the second transparent conductive layer 297 may also be arranged between the first transparent conductive layer 292 and the anode layer 293. The second transparent conductive layer 297 includes multiple transparent conductive sub-layers, and each of the multiple transparent conductive sub-layers electrically connects the transparent anode 2931 to the first driving unit 2911. With the improvement of the resolution of the first display area 210, due to the limitation of a volume of the electronic device 10, the first transparent conductive layer 292 cannot completely connect each subpixel 201, in this case, the first transparent conductive layer 292 and the second transparent conductive layer 297 cooperate with each other to connect to each subpixel 201 of the first display area 210 with a high-resolution.

The first planarization layer 298 is arranged between the anode layer 293 and the driving circuit layer 291, and multiple via holes 2981 penetrating through the first planarization layer 298 in a thickness direction of the planarization layer 298 are arranged on the first planarization layer 298, and the via holes 2981 are configured to make the transparent conducting circuits 2921 pass through to electrically connect the first driving unit 2911 to the transparent anode 2931. The transparent conducting circuits 2921 are routed through the via holes 2981 on the first planarization layer 298, and the routings of the transparent conducting circuits 2921 can be shorter to further reduce the interference of the transparent conducting circuits 2921 to light.

The common electrode layer 295 is arranged on the luminescent layer 294, and the anode layer 293 and the common electrode layer 295 are arranged on opposite sides of the subpixel 201, and are configured to jointly drive the subpixel 201. The common electrode layer 295 may be made of Indium Tin Oxide (ITO) material with a high light transmittance.

The second planarization layer 299 may be arranged on the common electrode layer 295. After the subpixel 201 is arranged in the pixel hole, the pixel hole is not filled by the subpixel 201. After the common electrode layer 295 is arranged on the subpixel 201, a groove will be formed. The second planarization layer 299 can fill the groove and cover the whole luminescent layer 294 to protect the luminescent layer 294.

The touch layer 290 may be arranged on the second planarization layer 299, and the touch layer 290 may be configured to detect a touch operation of a user. A polarizer (not illustrated) may be arranged on the touch layer 290, which can be configured to prevent internal light from being transmitted out and prevent the user from seeing components such as driving units at an inner surface of the touch layer 290. The touch layer 290 and the polarizer can be attached together and then arranged on the planarization layer 296.

It should be noted that in some other embodiments, some structures can be added or reduced as required, and the embodiments of the present disclosure are not limited herein. In some embodiments, at least one of the touch layer 290 and the polarizer may be reduced. For another example, a protective layer may be added between the second planarization layer 299 and the touch layer 290, and the protective layer may be made of a same material as the substrate 296.

In the various layers of the first display area 210, other layers excepting the driving circuit layer 291 having the first driving units 2911 are made of light-transmitting materials to improve the light transmittance of the first display area 210. In some embodiments, the substrate 296, the pixel definition layer 294, the common electrode layer 295, the first planarization layer 298, the second planarization layer 299 and the touch layer 290 of the first display area 210 may be all made of light-transmitting materials, and the signal lines in the anode layer 293 may be made of light-transmitting materials such as ITO or nano silver. The TFTs of the driving circuit layer 291 cannot be made of a light-transmitting material, and other parts of the driving circuit layer 291 except the TFTs may also be made of a light-transmitting material. It can be understood that technical solutions of improving the first display area 210 by improving the light transmittances of materials and changing the arrangement of routings are within the scope of protection of the present disclosure.

It should be noted that the second display area 220 can adopt a layered structure similar to that of the first display area 210. For details, please refer to the above-mentioned embodiment, and the details will not be repeated herein. At least one of a substrate, a pixel definition layer, a common electrode layer, a planarization layer, a touch layer and other layers of the second display area 220 may be made of the same light-transmitting material as that of the first display area 210. In some embodiments, the substrate of the second display area 220 may be made of light-transmitting materials such as glass or resin. At least one of the substrate, the pixel definition layer, the common electrode layer, the planarization layer, the touch layer and other layers of the second display area 220 can be made of different materials from that of the first display area 210. In some embodiments, signal lines in the anode layer 293 of the second display area 220 may be made of metal or alloy materials such as molybdenum, molybdenum aluminum molybdenum and argentum (Ag), and the second display area 220 is not provided with light shielding blocks, and a metal anode of the second display area 220 can be made of metal materials, such as magnesium (Mg), Ag, and aluminum (Al). The common electrode layer of the second display area 220 may be made of materials such as Mg and Ag. The common electrode layer of the second display area 220 is connected to an edge of the common electrode layer of the first display area 210 to form a complete common electrode layer 295. The luminescent layer of the second display area 220 includes multiple subpixels, and the materials of the subpixels of the second display area 220 may be the same as those of the subpixels 201 of the first display area 210, and the light transmittances of the subpixels of the second display area 220 is also the same as those of the subpixels 201 of the first display area 210. Also, the subpixels of the second display area 220 may also be different from the subpixels 201 of the first display area 210, so as to realize that the light transmittance of the first display area 210 is greater than that of the second display area 220.

As illustrated in FIG. 4, in the display apparatus 200 of the embodiments of the present disclosure, the pixel definition layer 294 may further include a second pixel definition region 2942, which may correspond to the driving circuit layer 291 and be located at a region of the pixel definition layer 294 where the first pixel definition region 2941 is not located, that is, an orthographic projection of the first driving unit 2911 on the pixel definition layer 294 is located in the second pixel definition region 2942.

It can be understood that the second pixel definition region 2942 may be formed with at least one second pixel unit a2, and when the at least one second pixel unit a2 is multiple in number, the multiple second pixel units a2 may be arranged at intervals. Each second pixel unit a2 may include multiple fourth subpixels 202, in some embodiments, the second pixel unit a2 may include a red subpixel, a green subpixel and a blue subpixel. In a direction parallel to the pixel definition layer 294, a cross-sectional area of the fourth subpixel 202 may be larger than that of the subpixel 201.

It can be understood that the second pixel definition region 2942 may be arranged in the second display area 220, and the second pixel definition region 2942 may be arranged adjacent to and connected to the first pixel definition region 2941. The first pixel definition region 2941 and the second pixel definition region 2942 may be located inside the cover plate 100, so that the cover plate 100 can protect the first pixel definition region 2941 and the second pixel definition region 2942.

It can be understood that the first pixel definition region 2941 and the second pixel definition region 2942 may be arranged in a same layer arrangement manner. The so-called same layer arrangement may mean that an outer surface of the first pixel definition region 2941 and an outer surface of the second pixel definition region 2942 may be in a same plane, and an inner surface of the first pixel definition region 2941 and an inner surface of the second pixel definition region 2942 may be in a same plane.

It can be understood that, in the direction parallel to the pixel definition layer 294, a cross section of the fourth subpixel 202 of the second pixel unit a2 may be circular or elliptical like the subpixel 201 of the first pixel unit a1, to reduce diffraction interference.

It can be understood that multiple second driving units (not illustrated) are arranged in a region of the driving circuit layer 291 corresponding to the second pixel definition region 2942, and each of the multiple second driving units is electrically connected to one fourth subpixel 202 of the second pixel unit a2 to drive the one fourth subpixel 202.

It can be understood that the anode layer 293 may be provided with multiple metal anodes (not illustrated), which may be arranged in the second display area 220, and each of the multiple metal anodes may be electrically connected to one fourth subpixel 202 of the second pixel unit a2. The display apparatus 200 may also include a conductive layer (not illustrated) arranged in the second display area 220, which is formed with multiple curved conducting circuits, and each metal anode is electrically connected to one fourth subpixel 202 through one conducting circuit.

In the display apparatus 200 of the embodiments of the present disclosure, the orthographic projection of the opaque first driving unit 2911 is located in the second pixel definition region 2942, and the opaque first driving unit 2911 will not affect the external light incident on the first pixel definition region 2941 at all, so that a light transmittance of the external light is high when it passes through a region corresponding to the first pixel definition region 2941. Moreover, the cross-sectional area of the second pixel unit a2 is larger than that of the subpixel 201, and the dimension of the subpixel 201 is smaller than that of the second pixel unit a2, therefore, the area occupied by the subpixel 201 is smaller than that of the second pixel unit a2, the pixel interval of the first display area 210 is larger, the light transmittance of the first display area 210 is higher, and the probability of diffraction phenomenon is lower.

It can be understood that in the direction parallel to the pixel definition layer 294, when the cross-sectional area of the fourth subpixel 202 is larger than that of the subpixel 201, a luminescent material with a specific attenuation frequency can be selected, so that the attenuation frequency of the fourth subpixel 202 is larger than that of the subpixel 201, thereby ensuring that the consistency of the display of the first display area 210 and the second display area 220 can be ensured, and the first display area 210 and the second display area 220 will not have an obvious sense of boundary when displaying information.

The light transmittance of the first display region 210 may be greater than that of the second display region 220. It can be understood that there are various ways to realize the light transmittance of the first display area 210 being greater than that of the second display area 220.

In some embodiments, the first display area 210 may include multiple subpixels 201, and the second display area 220 may include multiple fourth subpixels 202, and pixels per inch of the multiple subpixels 201 may be smaller than pixels per inch of the multiple fourth subpixels 202, so that an interval area between the multiple subpixels 201 in the first display area 210 is larger, which makes an increase in areas that can transmit light, thereby realizing that the light transmittance of the first display area 210 is greater than that of the second display area 220.

It can be understood that in order to further improve the light transmittance of the first display area 210, the subpixels 201 of the first display area 210 are made of light-transmitting materials, such as indium tin oxide.

It can be understood that the multiple fourth subpixels 202 and the multiple subpixels 201 may be arranged in an array. The arrangement of the subpixels 201 in the first display area 210 can be one of a standard RGB arrangement, a Pentile arrangement or a Delta arrangement, and the arrangement of the fourth subpixels 202 in the second display area 220 can be one of the standard RGB arrangement, the Pentile arrangement or the Delta arrangement. It should be noted that the subpixels 201 in the first display area 210 may also adopt other arrangements, and the fourth subpixels 202 in the second display area 220 may also adopt other arrangements.

For another example, multiple driving circuit layers 291 are arranged in the display apparatus 200. A first driving layer (not illustrated) is connected to the subpixels 201 and drives the subpixels 201, and a second driving layer (not illustrated) is connected to the fourth subpixels 202 and drives the fourth subpixel 202. The second driving layer is provided with via holes 2981 penetrating through a thickness direction thereof, and driving routings pass through the via holes 2981 to electrically connect the first driving units 2911 in the first driving layer to the subpixels 201.

It can be understood that the driving unit can adopt one of driving circuits such as 2T1C, 5T1C and 7T1C. In some embodiments, the first driving unit 2911 may adopt one of 2T1C, 5T1C and 7T1C, and the second driving unit may adopt one of 2T1C, 5T1C and 7T1C. Specifically, T refers to a thin film transistor and C refers to a capacitance. In order to improve the light transmittance of the first display area 210, the first driving unit 2911 arranged in the first display area 210 may be a simpler driving circuit than a main driving unit of the second display area 220, in some embodiments, the number of thin film transistors included in the first driving unit 2911 is less than that of the second driving unit. In some embodiments, the first driving unit 2911 may adopt one of 2T1C and 5T1C, and the second driving unit may adopt 7T1C. The number of opaque thin film transistors in the first driving unit 2911 is less, and thus the opaque part in the first display area 210 is less, which can improve the light transmittance of the first display area 210.

For another example, pixels of the first display area 210 and pixels of the second display area 220 may have a same physical structure, but the subpixels 201 in the first display area 210 may be connected in parallel to connect to one signal line to form a pixel set, so that the number of signal lines for connecting the subpixels 201 can be reduced, thereby improving the light transmittance of the first display area 210.

It can be understood that the above is merely examples of technical solutions for realizing the light transmittance of the first display area 210 being greater than that of the second display area 220, and the technical solutions of the embodiment of the present disclosure are not limited thereto, and other technical solutions for realizing that the light transmittance of the first display area 210 being greater than that of the second display area 220 are within the scope of protection of the present disclosure.

As illustrated in FIG. 13, FIG. 13 illustrates a second schematic structural view of the display apparatus illustrated in FIG. 1. The display apparatus 200 may further include a non-display area 230. The non-display area 230 may be located at a periphery of the second display area 220, and the non-display area 230 may be connected to the second display area 220.

It can be understood that the first driving units 2911 are located in the non-display area 230, and the transparent conducting circuits 2921 are connected to the subpixels 201 and the first driving units 2911, so that the first driving units 2911 can drive the subpixels 201 to emit light.

It can be understood that the non-display area 230 may have no display function and cannot display a picture. It can be understood that the non-display area 230 may be arranged in a top area of the electronic device 10, or the non-display area 230 may be arranged in a bottom area of the electronic device 10, or the non-display area 230 may be arranged in both the top and bottom areas of the electronic device 10, or the non-display area 230 may be set in the top and bottom areas and two opposite sides of the electronic device 10.

It can be understood that the transparent conducting circuit 2921 may be an arc-shaped routing. The transparent conducting circuit 2921 is made of a transparent material, such as indium tin oxide.

In the display apparatus 200 of the embodiment of the present disclosure, the first driving units 2911 are arranged in the non-display area 230, and the first driving units 2911 do not occupy a space of the first display area 210, so that the light transmittance of the first display area 210 can be higher, and the external light does not encounter the first driving unit 2911 in the first display area 210 to form a diffraction phenomenon, and the diffraction interference of the first display area 210 can be further reduced. Moreover, since each the transparent conducting circuits 2921 are routed in an arc shape, when the external light meets the arc shape, the diffraction phenomena formed in different parts of the arc shape will cancel each other out, which can also reduce the formation of diffraction stripes and reduce diffraction interference.

In some embodiments, each of the first pixel definition region 2941 of the first display area 210 and the second pixel definition region 2942 of the second display area 220 may be an OLED display layer, which can include layered structures stacked with each other such as a hole transport layer, an organic light-emitting layer and an electron transport layer. When an electric current passes between the anode layer 293 and the common electrode layer 295, electrons and holes injected by an electrode recombine in the luminescent layer to form excitons, and exciton radiation deactivates to emit photons and generate visible light.

Since OLED pixels can emit light by themselves, the emitted light may be transmitted to the outside of the display apparatus 200 and absorbed by human eyes. The emitted light may also be transmitted to the inside of the display apparatus 200. The light transmitted to the inside of the display apparatus 200 is generally called screen light leakage, and this part of light is not received by human eyes, which will affect a brightness of the display apparatus 200 on the one hand, and reduce the light transmittance of pixels and result in diffraction phenomenon on the other hand. In order to improve the brightness of the display apparatus 200, a reflective material, such as silver material, is often added to the anode layer 293 in the related art, such that when light passes through the OLED pixels, the screen light leakage of the first pixel definition region 2941 and the second pixel definition region 2942 can be reflected to the outside of the display apparatus 200 under the reflection of the silver material.

Adding reflective material to the anode layer 293 can improve the brightness of the display apparatus 200, but it will reduce the light transmittance of pixels in the display layer, and when light passes through the display apparatus 200, diffraction phenomena will occur, which will seriously affect the lighting and shooting effects of the image sensor 700.

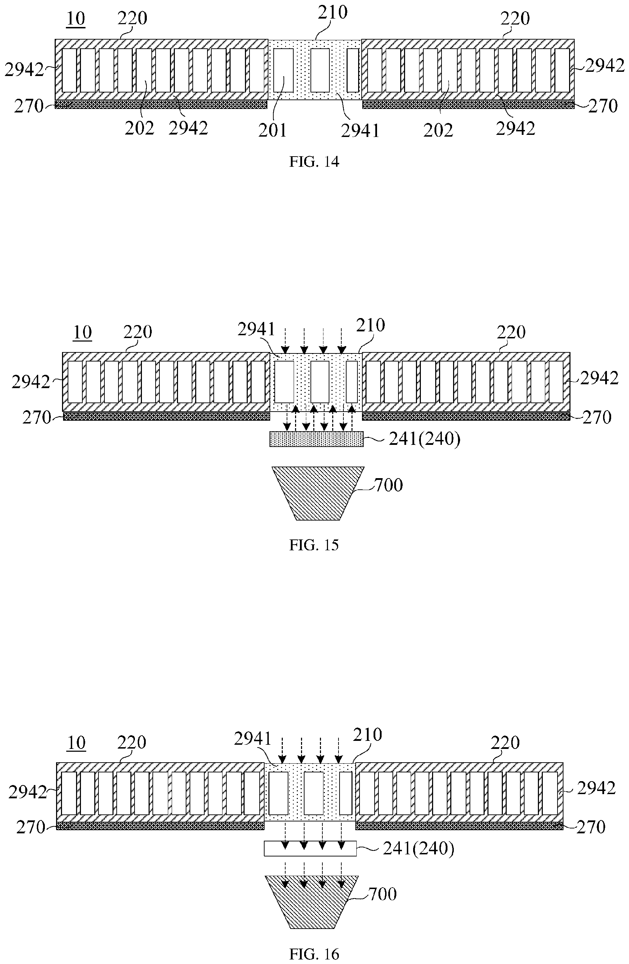

As illustrated in FIG. 14, FIG. 14 illustrates a third cross-sectional view of the display apparatus illustrated in FIG. 2 along the direction P1 to P2. In the display apparatus 200 of the embodiments of the present disclosure, for the second display area 220, a reflective material may be provided in the anode layer 293 corresponding to the second pixel definition region 2942 and thus a reflective layer 270 is formed in the second pixel definition region 2942 to ensure the display brightness of the display apparatus 200.

It can be understood that the reflective layer 270 may be disposed on a side, such as an inner side, of the second pixel definition region 2942 to ensure the display brightness of the display apparatus 200.

It can be understood that may not be provided with a reflective material in the anode layer 293, so that the reflective layer 270 is not formed correspondingly.

In order to give consideration to both the display brightness and the shooting effect of the image sensor 700, the display apparatus 200 of the embodiments of the present disclosure may further include a blocking member 240, which may be arranged between the first pixel definition region 2941 and the image sensor 700. The blocking member 240 can be switched between a first state and a second state. In the first state, the blocking member 240 can reflect the light emitted from the first pixel definition region 2941 and the second pixel definition region 2942 to the outside of the display apparatus 200 or can absorb the light emitted from the first pixel definition region 2941 and the second pixel definition region 2942. In the second state, the blocking member 240 may allow at least part of ambient light to pass through the display apparatus 200 and enter the image sensor 700.

As illustrated in FIGS. 15 and 16, FIG. 15 illustrates a first cross-sectional view of the display apparatus illustrated in FIG. 1 along M1 to M2, and FIG. 16 illustrates a second cross-sectional view of the display apparatus illustrated in FIG. 1 along M1 to M2. The blocking member 240 may be an electro-reflective layer 241, which may be arranged between the first pixel definition region 2941 and the image sensor 700 of the display apparatus 200. The electro-reflective layer 241 may be arranged directly face to the first pixel definition region 2941 and the first display area 210. Moreover, under the action of an electric current, the electro-reflective layer 241 can realize a reversible change from a colored state with a low light transmittance to an achromatic state with a high light transmittance.

In some embodiments, as illustrated in FIG. 15, the electro-reflective layer 241 of the embodiments of the present disclosure may be in the colored first state when no electricity is applied. In the first state, the electro-reflective layer 241 has a low light transmittance, and the light emitted from the first pixel definition region 2941 and the second pixel definition region 2942 cannot pass through the electro-reflective layer 241. In addition, the electro-reflective layer 241 may be made of a material with a reflective function, so that in the first state, the electro-reflective layer 241 can also reflect light emitted by the organic light-emitting layer to the outside of the display apparatus 200.

As illustrated in FIG. 16, the electro-reflective layer 241 of the embodiments of the present disclosure may be in the transparent second state when an electricity is applied. In the second state, the electro-reflective layer 241 has a high light transmittance, and ambient light can pass through the electro-reflective layer 241 and enter the image sensor 700. Furthermore, in the second state, the electro-reflective layer 241 can make at least part of the ambient light pass through the display apparatus 200 and enter the image sensor 700.

In an embodiment, the blocking member 240 may also be an electro-absorption layer (not illustrated), which may be arranged between the first pixel definition region 2941 and the image sensor 700 of the display apparatus 200. The electro-absorption layer may be arranged directly face to the first pixel definition region 2941 and the first display area 210. Moreover, under the action of an electric current, the electro-absorption layer can realize a reversible change from a colored state with a low light transmittance to an achromatic state with a high light transmittance.

In some embodiments, the electro-absorption layer of the embodiments of the present disclosure may be in the colored first state when no electricity is applied. In the first state, the electro-absorption layer has a low light transmittance, and the light emitted from the first pixel definition region 2941 and the second pixel definition region 2942 cannot pass through the electro-absorption layer, and can be absorbed by the electro-absorption layer. The electro-absorption layer of the embodiments of the present disclosure may be in the transparent second state when an electricity is applied. In the second state, the electro-absorption layer has high light transmittance, and ambient light can pass through the electro-absorption layer and enter the image sensor 700. Furthermore, in the second state, the electro-absorption layer can make at least part of the ambient light pass through the display apparatus 200 and enter the image sensor 700.

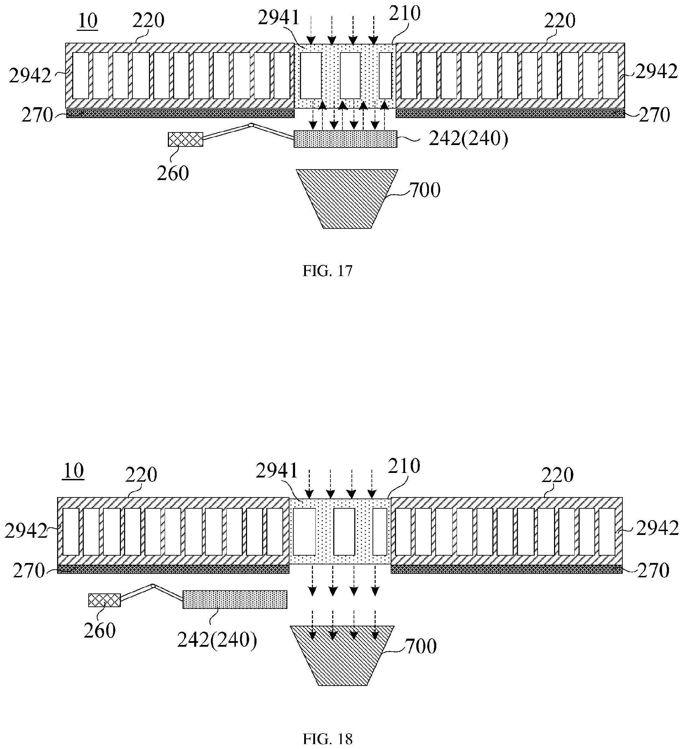

As illustrated in FIGS. 17 and 18, FIG. 17 illustrates a third cross-sectional view of the display apparatus illustrated in FIG. 1 along M1 to M2, and FIG. 18 illustrates a fourth cross-sectional view of the display apparatus illustrated in FIG. 1 along M1 to M2. The blocking member 240 may also be a reflective element 242. The electronic device 10 may also include a driving mechanism 260, which can be electrically connected with the reflective element 242. Under the action of the driving mechanism 260, the reflective element 242 can be switched between a first state and a second state. In the first state, the reflective element 242 is arranged to directly face to the first pixel definition region 2941, and in the second state, the reflective element 242 is at least partially offset from the first pixel definition region 2941.

As illustrated in FIG. 17, when the reflective element 242 is in the first state, a reflective surface of the reflective element 242 can be arranged to directly face to a light-emitting surface of the first pixel definition region 2941, and a projection of the reflective surface of the reflective element 242 on the first pixel definition region 2941 may cover the light-emitting surface of the first pixel definition region 2941, so that the reflective element 242 can fully reflect the light emitted from the first pixel definition region 2941 to the display apparatus 200.

As illustrated in FIG. 18, when the reflective element 242 is in the second state, the reflective surface of the reflective element 242 may be completely staggered or partially staggered from the light emitting surface of the first pixel definition region 2941. The staggered arrangement may mean that the projection of the reflective element 242 on the first pixel definition region 2941 does not intersect with the first pixel definition region 2941 at all, and the projection of the reflective surface on the first pixel definition region 2941 does not intersect with the projection of the light emitting surface on the first pixel definition region 2941 at all. In this case, the reflective element 242 does not block the first pixel definition region 2941 at all, and the light emitted from the first pixel definition region 2941 can directly enter the display apparatus 200 without reflection and be received and detected by the image sensor 700.

It can be understood that the staggered arrangement may also mean that the projection of the reflective element 242 on the first pixel definition region 2941 does not partially intersect with the first pixel definition region 2941, and the projection of the reflective surface on the first pixel definition region 2941 does not partially intersect with the projection of the light emitting surface on the first pixel definition region 2941. In this case, the reflective element 242 does not completely block the first pixel definition region 2941, and part of the light emitted from the first pixel definition region 2941 can directly enter the display apparatus 200 without reflection and be received and detected by the sensor.

Of course, the staggered arrangement may also mean that there is a preset included angle between the reflective surface and the light emitting surface of the reflective element 242, which can be greater than zero and less than 360 degrees, so that the reflective surface is not directly faced to the light emitting surface. In this case, part of the light emitted by the first pixel definition region 2941 can pass through the reflective element 242 without reflection, and thus enter the display apparatus 200 and be received and detected by the image sensor 700.

It can be understood that the driving mechanism 260 can be a motor driving mechanism. In some embodiments, the driving mechanism 260 can include a motor and a slide rail. The slide rail can be arranged at a side, such as an inner side, of the first pixel definition region 2941. A rotating shaft of the motor can be connected to the reflective element 242, and the motor can drive the reflective element 242 to slide on the slide rail, so that the reflective element 242 may be arranged to directly face to the first pixel definition region 2941 and cover the first display area 210, or the reflective element 242 may be arranged offset from the first pixel definition region 2941 and facing away from the first display area 210.

In some embodiments, the driving mechanism 260 may also be an electromagnetic driving mechanism. In some embodiments, the driving mechanism 260 can include two magnets, a spring and an electromagnetic circuit. The two magnets are respectively arranged on the reflective element 242 and the first pixel definition region 2941. One end of the spring is connected to the reflective element 242, and the other end of the spring may be fixed on the second display area 220. When the electromagnetic circuit is turned on, the reflective element 242 and the first pixel definition region 2941 are under the action of magnetic attraction, and the reflective element 242 is arranged to directly face to the first pixel definition region 2941 and thus covers the first display area 210, in this case, the spring is stretched. When the electromagnetic circuit is disconnected, the magnetic attraction between the reflective element 242 and the first pixel definition region 2941 disappears, and the reflective element 242 is pulled back to an initial position by the spring, that is to say, the reflective element 242 is staggered from the first pixel definition region 2941 and facing away from the first display area 210.

Of course, the driving mechanism 260 of the embodiments of the present disclosure is not limited to the above examples, and the driving mechanism 260 may also be other driving mechanisms, such as a cylinder driving mechanism, a motor gear driving mechanism, and a motor belt driving mechanism. Any driving mechanism 260 that can switch the reflective element 242 between the first state and the second state is within the scope of protection of the present disclosure.

As of the display apparatus 200 and the electronic device 10 of the embodiments of the present disclosure, the blocking member 240 can be switched between the first state and the second state. When the blocking member 240 is in the first state, the blocking member 240 can completely block the first pixel definition region 2941, and the blocking member 240 can completely reflect the light emitted from the first pixel definition region 2941 to the outside of the display apparatus 200 or completely absorb the light emitted from the first pixel definition region 2941, such that the brightness of the display apparatus 200 can be ensured and the reflection can be reduced. When the blocking member 240 is in the second state, the blocking member 240 cannot completely block the first pixel definition region 2941, and light can directly enter the display apparatus 200 without passing through the blocking member 240 and be received by the image sensor 700. Therefore, on the one hand, the light transmittance of the display apparatus 200 can be improved, and on the other hand, the subpixels 201 in the first pixel definition region 2941 will not form diffraction gratings, and the shooting effect of the image sensor 700 will not be affected.

The display apparatus and the electronic device provided by the embodiments of the present disclosure have been described in detail above. Specific examples herein are used to explain the principle and implementation of the present disclosure, and the descriptions of the above examples are merely used to help understand the present disclosure. Further, according to the idea of the present disclosure, there will be changes in the specific implementation and application scope for those skilled in the art. To sum up, the contents of this specification should not be understood as limitations on the present disclosure.

## Claims

1.    A display apparatus, comprising:

a pixel definition layer, comprising a first pixel definition region, wherein at least one first pixel unit is formed in the first pixel definition region, and each of the at least one first pixel unit comprises an elliptical subpixel or a circular subpixel;
an anode layer, defined on a side of the pixel definition layer and comprising a plurality of transparent anodes, wherein each of the plurality of transparent anodes is connected to one subpixel;
a driving circuit layer, arranged at intervals on a side of the anode layer back from the pixel definition layer, wherein the driving circuit layer is provided with a plurality of first driving units in a region apart from the first pixel definition region; and
a first transparent conductive layer, arranged between the anode layer and the driving circuit layer, wherein the first transparent conductive layer is formed with a plurality of curved transparent conducting circuits, and each of the plurality of transparent anodes is electrically connected to one of the plurality of first driving units through one of the plurality of transparent conducting circuits.

**2.** The display apparatus according to claim 1, wherein the subpixel comprises a main body portion and a protrusion portion, the protrusion portion comprises a plurality of protrusions arranged at intervals, and the plurality of protrusions are arranged around an outer periphery of the main body portion and are arranged to protrude from the outer periphery of the main body portion.

**3.** The display apparatus according to claim 1, wherein the subpixel comprises a main body portion and an edge portion, the edge portion is arranged around an outer periphery of the main body portion, and an outer periphery of the edge portion comprises a plurality of curves connected end to end, and curvatures of at least two of the plurality of curves vary.

**4.** The display apparatus according to claim 1, wherein a diameter of a cross section of the subpixel in a direction parallel to the pixel definition layer is a non-integer multiple of a half of a target wavelength, so that an energy of light with the target wavelength is concentrated in a main diffraction spectrum when the light with the target wavelength is incident on the subpixel.

**5.** The display apparatus according to claim 1, wherein the first pixel unit comprises a first subpixel, a second subpixel and a third subpixel arranged at intervals; and
in a direction parallel to the pixel definition layer, a cross-sectional area of each of the first subpixel and the second subpixel is larger than a cross-sectional area of the third subpixel.

**6.** The display apparatus according to claim 5, wherein a luminescence decay frequency of each of the first subpixel and the second subpixel is greater than a luminescence decay frequency of the third subpixel.

**7.** The display apparatus according to claim 1, wherein a number of the subpixel is at least two, and the at least two subpixels are arranged at intervals; and
in a direction parallel to the pixel definition layer, a diameter of a cross section of each of the at least two subpixels is not equal to a half of a spacing between two adjacent subpixels of the at least two subpixels.

**8.** The display apparatus according to claim 1, further comprising:
a second transparent conductive layer, arranged between the anode layer and the driving circuit layer, wherein the second transparent conductive layer comprises a plurality of transparent conductive sub-layers, and each of the plurality of transparent conductive sub-layers is configured to electrically connect one of the plurality of transparent anodes to one of the plurality of first driving units.

**9.** The display apparatus according to claim 1, further comprising:
a planarization layer, arranged between the anode layer and the driving circuit layer, wherein the planarization layer is provided with a plurality of via holes penetrating through the planarization layer in a thickness direction of the planarization layer, and the plurality of via holes are configured to make the plurality of transparent conducting circuits to pass through to electrically connect the plurality of first driving units and the plurality of transparent anodes.

**10.** The display apparatus according to claim 1, wherein the pixel definition layer further comprises a second pixel definition region, and an orthographic projection of each of the plurality of the first driving units on the pixel definition layer is located in the second pixel definition region.

**11.** The display apparatus according to claim 10, wherein at least one second pixel unit is formed in the second pixel definition region, each of the at least one second pixel unit comprises a plurality of fourth subpixels, and a region of the driving circuit layer corresponding to the second pixel definition region is provided with a plurality of second driving units, and each of the plurality of second driving units is electrically connected to one of the plurality of fourth subpixels to drive the one of the plurality of fourth subpixels .

**12.** The display apparatus according to claim 10, further comprising:

a blocking member, arranged at a side of the pixel definition layer facing away from the anode layer;
a driving mechanism, electrically connected to the blocking member, wherein the driving mechanism is configured to switch the blocking member between a first state and a second state;
wherein in the first state, the blocking member is arranged correspond to the first pixel definition region; and
wherein in the second state, the blocking member is arranged correspond to the second pixel definition region.

**13.** An electronic device, comprising:

a display apparatus, comprising: a pixel definition layer, an anode layer, a first transparent conductive layer and a driving circuit layer stacked sequentially, wherein the pixel definition layer comprises a first pixel definition region, and at least one first pixel unit is formed in the first pixel definition region, and each of the at least one first pixel unit comprises an elliptical subpixel or a circular subpixel; the anode layer comprises a plurality of transparent anodes, and each of the plurality of transparent anodes is connected to one subpixel; the driving circuit layer is provided with a plurality of first driving units in a region apart from the first pixel definition region; the first transparent conductive layer is formed with a plurality of curved transparent conducting circuits; and each of the plurality of transparent anodes is electrically connected to one of the plurality of first driving units through one of the plurality of transparent conducting circuits; and
an image sensor, arranged on a side of the display apparatus, wherein the image sensor is configured to receive light passing through the display apparatus.

**14.** The electronic device according to claim 13, wherein the subpixel comprises a main body portion and a protrusion portion, the protrusion portion comprises a plurality of protrusions arranged at intervals, and the plurality of protrusions are arranged around an outer periphery of the main body portion and are arranged to protrude from the outer periphery of the main body portion.

**15.** The electronic device according to claim 13, wherein the subpixel comprises a main body portion and an edge portion, the edge portion is arranged around an outer periphery of the main body portion, and an outer periphery of the edge portion comprises a plurality of curves connected end to end, and curvatures of at least two of the plurality of curves vary.

**16.** The electronic device according to claim 13, wherein a diameter of a cross section of the subpixel in a direction parallel to the pixel definition layer is a non-integer multiple of a half of a target wavelength, so that an energy of light with the target wavelength is concentrated in a main diffraction spectrum when the light with the target wavelength is incident on the subpixel.

**17.** The electronic device according to claim 13, wherein the first pixel unit comprises a first subpixel, a second subpixel and a third subpixel arranged at intervals; and
in a direction parallel to the pixel definition layer, a cross-sectional area of each of the first subpixel and the second subpixel is larger than a cross-sectional area of the third subpixel.

**18.** The electronic device according to claim 13, wherein a number of the subpixel is at least two, and the at least two subpixels are arranged at intervals; and
in a direction parallel to the pixel definition layer, a diameter of a cross section of each of the at least two subpixels is not equal to a half of a spacing between two adjacent subpixels of the at least two subpixels.

**19.** The electronic device according to claim 13, wherein the pixel definition layer further comprises a second pixel definition region, and an orthographic projection of each of the plurality of the first driving units on the pixel definition layer is located in the second pixel definition region.

**20.** The electronic device according to claim 19, wherein the display apparatus further comprises:

a blocking member, arranged at a side of the pixel definition layer facing away from the anode layer;
a driving mechanism, electrically connected to the blocking member, wherein the driving mechanism is configured to switch the blocking member between a first state and a second state;
wherein in the first state, the blocking member is arranged correspond to the first pixel definition region; and
wherein in the second state, the blocking member is arranged correspond to the second pixel definition region.

FIG. 1

FIG. 2

FIG. 3

FIG. 4

FIG. 5

294

2941

2013
2011 } 201

FIG. 6

294

2941

2016

2015

2014

a1

FIG. 7

294    201    d  a    201

2941

FIG. 8

FIG. 9

FIG. 10

FIG. 11

201

290

299

295

2942

2941

294

2931

293
297

2921

292
298

2911

291

296

2981

FIG. 12

200    210

230

220

FIG. 13

FIG. 14

FIG. 15

FIG. 16

FIG. 17

FIG. 18

## INTERNATIONAL SEARCH REPORT

| | International application No. |
|---|---|
| | **PCT/CN2021/110586** |

**A.    CLASSIFICATION OF SUBJECT MATTER**

H01L 27/32(2006.01)i；  H01L 51/52(2006.01)n

According to International Patent Classification (IPC) or to both national classification and IPC

**B.    FIELDS SEARCHED**

Minimum documentation searched (classification system followed by classification symbols)

H01L27/-;H01L51/-;G09G3/32

Documentation searched other than minimum documentation to the extent that such documents are included in the fields searched

Electronic data base consulted during the international search (name of data base and, where practicable, search terms used)

CNABS, CNTXT, VEN, USTXT, WOTXT, EPTXT, CNKI, ISI: applicant, inventor, 显示, 圆, 椭圆, 像素, 衍射, 透明, 透过, 透光, 阻挡, 遮光, 反射, 吸收, 电致, 波长, 平坦, 全面屏, 屏占比, display, circ+, round, ellipse, pixel, diffract+, transimi+, transparen+, reflect+, block+, absorb+, shield+, wavelength

**C.    DOCUMENTS CONSIDERED TO BE RELEVANT**

| Category* | Citation of document, with indication, where appropriate, of the relevant passages | Relevant to claim No. |
|---|---|---|
| Y | CN 110767672 A (YUNGU (GU'AN) TECHNOLOGY CO., LTD.; KUNSHAN GOVISIONOX OPTOELECTRONICS CO., LTD.; KUNSHAN VISIONOX DISPLAY CO., LTD.) 07 February 2020 (2020-02-07)<br>      description 57-89, figures 1-8 | 1-20 |
| Y | CN 111710276 A (WUHAN TIANMA MICROELECTRONICS CO., LTD.) 25 September 2020 (2020-09-25)<br>      description paragraphs 11, 43-54 | 1-20 |
| Y | CN 111381702 A (BEIJING XIAOMI MOBILE SOFTWARE CO., LTD.) 07 July 2020 (2020-07-07)<br>      description paragraphs 32-53, figures 1, 2 | 12, 20 |
| A | CN 111341936 A (KUNSHAN GOVISIONOX OPTOELECTRONICS CO., LTD.) 26 June 2020 (2020-06-26)<br>      entire document | 1-20 |
| A | CN 110767714 A (KUNSHAN GOVISIONOX OPTOELECTRONICS CO., LTD.) 07 February 2020 (2020-02-07)<br>      entire document | 1-20 |

☑ Further documents are listed in the continuation of Box C.        ☑ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **08 September 2021** | **29 September 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2021/110586**

**C.     DOCUMENTS CONSIDERED TO BE RELEVANT**

| Category* | Citation of document, with indication, where appropriate, of the relevant passages | Relevant to claim No. |
|---|---|---|
| A | CN 111046599 A (KUNSHAN GOVISIONOX OPTOELECTRONICS CO., LTD.) 21 April 2020 (2020-04-21)<br>entire document | 1-20 |
| A | CN 110767729 A (GUANGDONG OPPO MOBILE TELECOMMUNICATIONS CORP., LTD.) 07 February 2020 (2020-02-07)<br>entire document | 1-20 |
| A | CN 110017969 A (TSINGHUA UNIVERSITY; OPPO GUANGDONG MOBILE TELECOMMUNICATIONS CO., LTD.) 16 July 2019 (2019-07-16)<br>entire document | 1-20 |

Form PCT/ISA/210 (second sheet) (January 2015)

**INTERNATIONAL SEARCH REPORT**
Information on patent family members

International application No.

**PCT/CN2021/110586**

| Patent document cited in search report | | | Publication date (day/month/year) | Patent family member(s) | | | Publication date (day/month/year) |
|---|---|---|---|---|---|---|---|
| CN | 110767672 | A | 07 February 2020 | EP | 3712948 | A4 | 03 March 2021 |
| | | | | TW | I698689 | B | 11 July 2020 |
| | | | | EP | 3712948 | A1 | 23 September 2020 |
| | | | | KR | 20200083620 | A | 08 July 2020 |
| | | | | JP | 2021507289 | A | 22 February 2021 |
| | | | | CN | 110767672 | B | 17 November 2020 |
| | | | | TW | 201921064 | A | 01 June 2019 |
| | | | | US | 2020219967 | A1 | 09 July 2020 |
| | | | | WO | 2020029559 | A1 | 13 February 2020 |
| CN | 111710276 | A | 25 September 2020 | None | | | |
| CN | 111381702 | A | 07 July 2020 | None | | | |
| CN | 111341936 | A | 26 June 2020 | None | | | |
| CN | 110767714 | A | 07 February 2020 | WO | 2020192054 | A1 | 01 October 2020 |
| CN | 111046599 | A | 21 April 2020 | CN | 111046599 | B | 23 June 2020 |
| CN | 110767729 | A | 07 February 2020 | None | | | |
| CN | 110017969 | A | 16 July 2019 | CN | 110017969 | B | 10 April 2020 |

Form PCT/ISA/210 (patent family annex) (January 2015)

**EP 4 228 001 A1**

**Patent documents cited in the description**

- CN 202011097946